(19) **Europäisches Patentamt / European Patent Office / Office européen des brevets**

(11) **EP 2 486 607 B1**

(12) # FASCICULE DE BREVET EUROPEEN

(45) Date de publication et mention de la délivrance du brevet:
**08.03.2017 Bulletin 2017/10**

(21) Numéro de dépôt: **10776760.0**

(22) Date de dépôt: **30.09.2010**

(51) Int Cl.:
**H01L 51/10** *(2006.01)*

(86) Numéro de dépôt international:
**PCT/FR2010/000650**

(87) Numéro de publication internationale:
**WO 2011/042619 (14.04.2011 Gazette 2011/15)**

(54) **MÉMOIRE ORGANIQUE À DOUBLE GRILLE ET PROCÉDÉ DE RÉALISATION**

ORGANISCHE DUAL-GATE-SPEICHER UND HERSTELLUNGSVERFAHREN DAFÜR

ORGANIC DUAL-GATE MEMORY AND METHOD FOR PRODUCING SAME

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **05.10.2009 FR 0904749**

(43) Date de publication de la demande:
**15.08.2012 Bulletin 2012/33**

(73) Titulaire: **Commissariat à l'Énergie Atomique et aux Énergies Alternatives**
**75015 Paris (FR)**

(72) Inventeurs:
- **GWOZIECKI, Romain**
  **F-52800 Foulain (FR)**
- **BENWADIH, Mohamed**
  **F-94500 Champigny-sur-Marne (FR)**
- **CORONEL, Philippe**
  **F-38530 Barraux (FR)**
- **JACOB, Stéphanie**
  **F-38870 Saint Siméon de Bressieux (FR)**

(74) Mandataire: **Talbot, Alexandre et al**
**Cabinet Hecké**
**Europole, BP 1537**
**10, rue d'Arménie**
**38025 Grenoble Cedex 1 (FR)**

(56) Documents cités:
EP-A2- 1 367 659    US-A1- 2009 101 962
US-B1- 7 042 755

- **LLOYD-HUGHES J ET AL: "Polymer Transistor Performance Monitored by Terahertz Spectroscopy", 2006 JOINT 31ST INTERNATIONAL CONFERENCE ON INFRARED AND MILLIMETER WAVES AND 14TH INTERNATIONAL CONFERENCE ON TERAHERTZ ELECTRONICS: SHANGHAI, CHINA, 18 - 22 SEPTEMBER 2006, IEEE, PISCATAWAY, NJ, 1 septembre 2006 (2006-09-01), pages 203-203, XP031096236, ISBN: 978-1-4244-0399-8**
- **FACCHETTI A; KIM C; YOON M-H; MARKS T J: "Interfacial phenomena affecting charge transport in small molecule organic thin-film transistors", MATERIALS RESEARCH SOCIETY SYMPOSIUM PROCEEDINGS - ORGANIC ELECTRONICS: MATERIALS, DEVICES AND APPLICATIONS, vol. 965, 27 novembre 2006 (2006-11-27), - 1 décembre 2006 (2006-12-01), pages 258-263, XP002566238,**
- **CUI T ET AL: "DUAL-GATE PENTACENE ORGANIC FIELD-EFFECT TRANSISTORS BASED ON A NANOASSEMBLED SIO2 NANOPARTICLE THIN FILM AS THE GATE DIELECTRIC LAYER", APPLIED PHYSICS LETTERS, AIP, AMERICAN INSTITUTE OF PHYSICS, MELVILLE, NY, US, vol. 86, no. 6, 7 février 2005 (2005-02-07), pages 64102-01, XP001237999, ISSN: 0003-6951, DOI: DOI:10.1063/1.1861126**
- **ANONYMOUS: 'Organic chemistry - Wikipedia, the free encyclopedia', [en ligne] 09 Janvier 2014, XP055095446 Extrait de l'Internet: <URL:http://en.wikipedia.org/wiki/Organic_c hemistry> [extrait le 2014-01-09]**

EP 2 486 607 B1

## Description

### Domaine technique de l'invention

L'invention est relative à un dispositif mémoire comportant une première électrode de grille, un premier diélectrique de grille, un matériau semi-conducteur organique, des électrodes de source et de drain définissant une surface inter-électrodes.

L'invention est également relative à un procédé de réalisation de dispositif mémoire organique.

### État de la technique

L'électronique organique est devenue un champ de recherche majeur. La majorité des dispositifs élémentaires connus en électronique silicium est en train d'être réalisée ou est déjà réalisée en électronique organique.

Cependant, les matériaux étant différents, les phénomènes physiques qui entrent en jeu sont également différents et certains blocs technologiques sont difficilement transposables. C'est notamment le cas des cellules mémoire en matériaux organiques. Il est actuellement difficile de réaliser des mémoires organiques qui soient faciles à mettre en oeuvre et qui présentent des caractéristiques électriques suffisamment performantes pour trouver des applications quotidiennes.

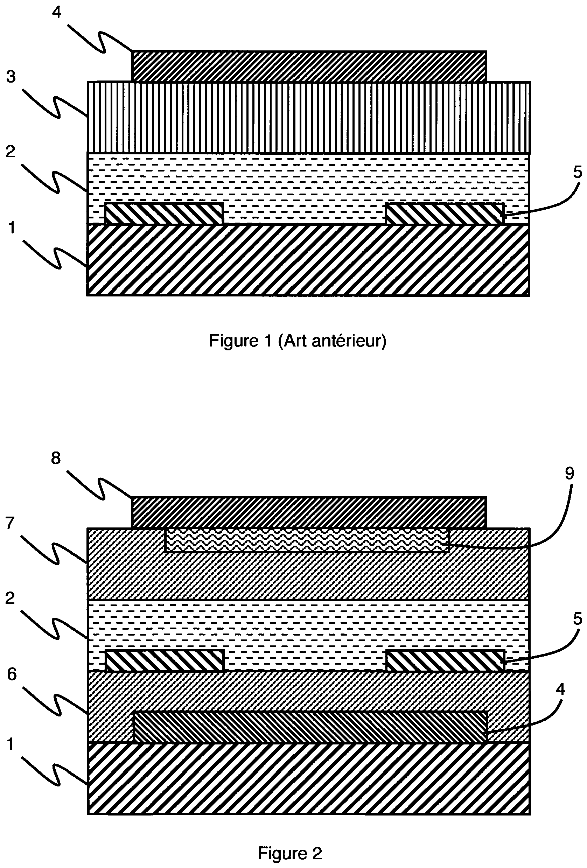

Comme illustré à la figure 1, de manière conventionnelle, le dispositif mémoire organique est formé à partir d'un transistor. Le dispositif mémoire comporte, sur un substrat 1, un matériau semi-conducteur organique 2 recouvert par une couche en matériau ferroélectrique 3 et une électrode de grille 4. Des électrodes de source et de drain 5 sont disposées en contact du matériau semi-conducteur organique 2 et définissent le canal du transistor. Le matériau ferroélectrique 3 réalise simultanément la fonction d'isolant de grille et de zone de rétention de l'information.

Ces dispositifs mémoire ne sont pas très performants car ils ne permettent pas de combiner de bonnes propriétés de stockage de l'information et de bonnes performances électriques du transistor, généralement associées à une bonne conduction dans le canal. Ainsi, ces dispositifs présentent des problèmes de perte de l'information lors de la lecture de l'état mémorisé.

Le document US 2009/0101962 divulgue un dispositif semi-conducteur ou un dispositif mémoire.

Le document EP 1 367 659 divulgue un transistor à effet de champ organique.

### Objet de l'invention

L'invention a pour objet un dispositif mémoire qui est facile à mettre en oeuvre et qui présente des performances électriques élevées, notamment en vitesse de lecture et en fiabilité de stockage.

L'invention a également pour objet un procédé de réalisation du dispositif mémoire qui soit facile à mettre en oeuvre et qui comporte un nombre restreint d'étapes technologiques, par exemple, par les techniques d'impression.

Le dispositif selon l'invention est caractérisé par l'objet de la revendication 1.

Le procédé selon l'invention est caractérisé par l'objet de la revendication 4.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

- la figure 1 représente, de manière schématique, en coupe, un dispositif mémoire selon l'art antérieur,
- les figures 2 à 11 représentent, de manière schématique en coupe, différents modes de réalisation d'un dispositif selon l'invention
- le figure 12 représente, de manière schématique, en vue de dessus, un mode de réalisation d'un dispositif multibit selon l'invention,
- les figures 13 et 14 représentent, de manière schématique, en vue de dessus, des dispositions du matériau semi-conducteur et des électrodes de source et de drain selon l'invention.

### Description de modes de réalisation préférentiels de l'invention

Le dispositif mémoire est formé à partir d'un transistor organique à double grille, c'est-à-dire un transistor ayant deux grilles disposées de part et d'autre du canal. Le canal du transistor est formé dans un matériau semi-conducteur organique 2. Le semi-conducteur peut être sous la forme d'une seule couche ou sous la forme d'un empilement de couches en matériaux distincts. Comme illustré à la figure 2, le dispositif mémoire organique comporte successivement une première électrode de grille 4, un premier diélectrique de grille 6, un matériau semi-conducteur organique 2, un second diélectrique de grille 7 et une seconde électrode grille 8. Les deux électrodes de grille sont donc disposées de part et d'autre du matériau semi-conducteur organique.

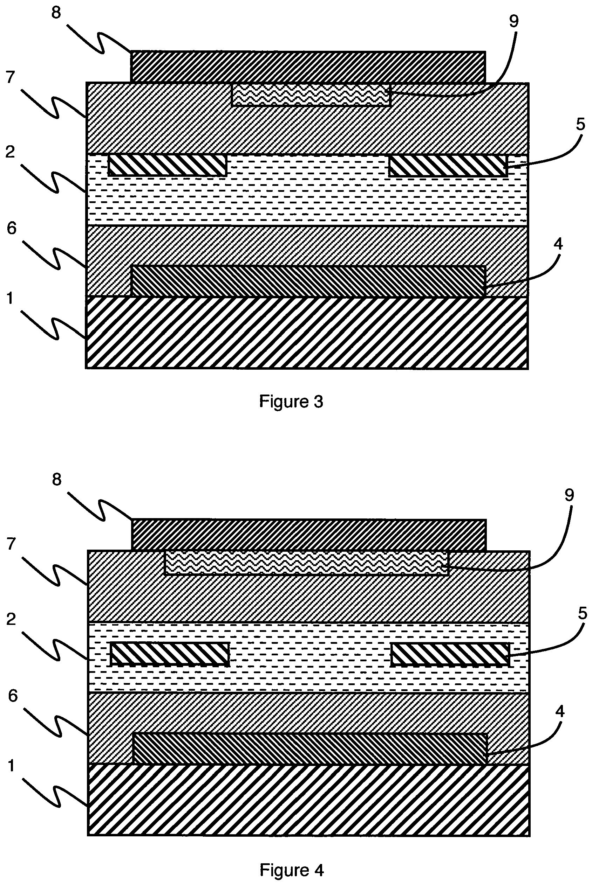

Le dispositif mémoire comporte également des électrodes de source et de drain 5 disposées entre les premier et second diélectriques de grille 6 et 7. Les électrodes de source et de drain 5 définissent dans le matériau semi-conducteur 2 une surface inter-électrodes 2a également appelée surface active. La surface inter-électrodes 2a correspond à l'intersection de la surface du matériau semi-conducteur 2 avec la surface délimitée par les extrémités des électrodes de source et de drain. Ainsi, dans la majorité des cas, la surface inter-électrodes 2a comprend la zone immédiatement comprise entre les électrodes de source et de drain 5 mais également la surface des électrodes de source et de drain 5 qui sont déposées ou qui sont recouvertes par le matériau semi-conducteur 2. La surface inter-électrodes 2a comprend schématiquement la surface délimitée par les électrodes de source et de drain 5 et qui peut être assimilée au canal et la surface de chacune des électrodes de source et de drain 5 dans la mesure où elles sont recouvertes ou elles recouvrent le matériau semi-conducteur 2. La surface assimilée au canal correspond à la surface qu'empruntent la majorité des porteurs de charge entre les électrodes de source et de drain 5. Comme illustré aux figures 2 et 3, ces électrodes de source et de drain 5 peuvent être disposées en contact du premier 6 ou du second 7 diélectrique de grille. Les électrodes de source et de drain 5 peuvent également être enrobées par le matériau semi-conducteur organique 2 (figure 4), c'est-à-dire comprises verticalement entre deux portions du matériau semi-conducteur organique 2. Les électrodes de source et de drain 5 sont sensiblement sur un plan parallèle à l'interface entre le premier diélectrique de grille 6 et le matériau semi-conducteur organique 2.

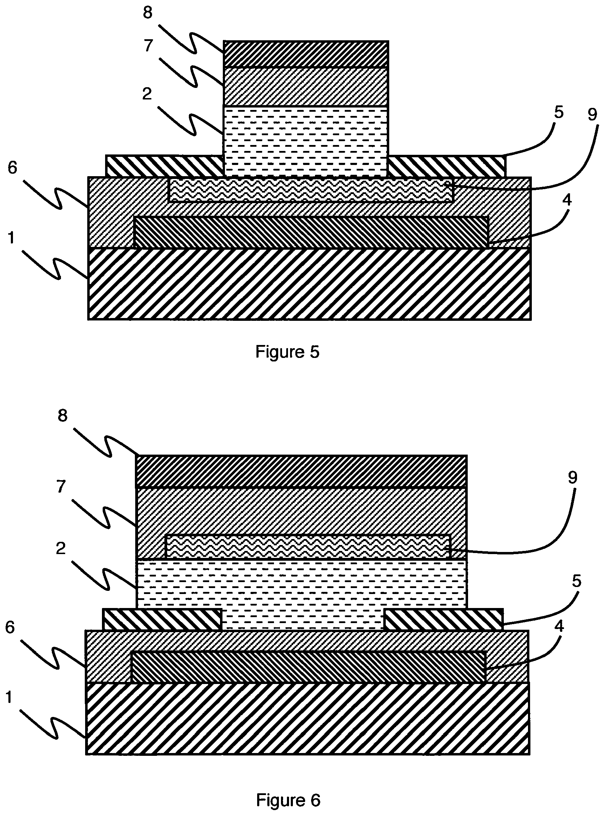

Les électrodes de source et de drain 5 sont en contact électrique avec le matériau semi-conducteur organique 2. Comme illustré à la figure 5, les électrodes 5 peuvent être disposées de part et d'autre du matériau semi-conducteur 2, ou le matériau semi-conducteur 2 peut recouvrir partiellement ou complètement les électrodes de source et de drain 5 (figures 6 et 2).

Le dispositif mémoire comporte également une zone de piégeage 9 de charges électriques. Cette zone de piégeage 9 de charges est en regard de la zone inter-électrodes 2a. La surface de la zone de piégeage 9 peut être morcelée (figures 2 et 3). La zone de piégeage peut être plus grande que la zone située entre les électrodes de sorte que la zone de piégeage peut être partiellement ou totalement en regard d'une ou des électrodes. Plus la surface en regard entre la zone de piégeage 9 et la zone inter-électrodes 2a est importante et plus l'effet de la zone de piégeage sera important sur les caractéristiques de conduction des charges électriques du canal, à densité de charge constante dans la zone de piégeage 9.

La zone de piégeage 9 est disposée entre le matériau semi-conducteur organique 2 et une des électrodes de grille 6 et 7. La zone de piégeage 9 est en contact électrique avec l'électrode de grille 6, 7 ou avec le matériau semi-conducteur 2. Ainsi, la zone de piégeage 9 peut être en contact direct avec l'électrode de grille 6, 7 ou avec le matériau semi-conducteur 2. Il est également possible que la zone de piégeage soit séparée de l'électrode de grille ou du matériau semi-conducteur par au moins un matériau électriquement conducteur. De cette manière, il est possible d'injecter des charges depuis l'électrode de grille 6 et 7 ou le canal du transistor vers la zone de piégeage 9 des charges.

Dans un mode de réalisation particulier, la zone de piégeage 9 est disposée entre un des diélectriques de grille 6 ou 7 et l'électrode de grille associée 4 ou 8 (figures 2, 3, 4, 7 et 8). Dans ce cas de figure, le matériau constituant la zone de piégeage 9 est formé avant le premier diélectrique de grille 6 ou après le second diélectrique de grille 7. Il est également possible de structurer l'électrode de grille pour incorporer le matériau piégeur de charge dans la structure de l'électrode de grille. Le matériau piégeur de charge est un matériau polymère conducteur ionique, par exemple un ionomère composé d'un squelette hydrophobe de type poly(tetrafluoroethylene) (PTFE) sur lequel sont greffées des chaînes pendantes perfluorées (perfluorovinylether) terminées par des groupes sulfoniques commercialisé par la société DuPont sous le nom de nafion®.

Dans le cas de la figure 3 par exemple, la zone de piégeage 9 peut aussi être réalisée par dégradation d'un matériau semi-conducteur déposé spécifiquement (non compris dans l'invention). Cependant, il est également envisageable de former la zone de piégeage 9 par dégradation d'une zone du diélectrique de grille. La portion dégradée du diélectrique de grille 6 ou 7 présente alors des caractéristiques électriques différentes du reste du matériau. Le diélectrique de grille dégradé présente une densité d'états de surface plus importante et il peut conserver de manière significative des charges accumulées. La dégradation localisée du diélectrique de grille peut être réalisée par exemple par traitement physique, chimique, laser ou par traitement plasma.

Pour avoir la définition d'un état haut et d'un état bas, il est nécessaire de créer un décalage notable des tensions de seuil. Ce décalage est proportionnel à la densité d'états pièges à créer et inversement proportionnel à la capacité électrique du matériau isolant situé à l'interface où les états pièges sont créés. La relation donnant le décalage est la suivante :

$$\Delta = e \cdot \frac{N_{ss}}{C_{OX}}$$

avec $e$ la charge de l'électron, $N_{ss}$ la densité d'états de pièges et $C_{ox}$ la capacité diélectrique.

A titre d'exemple, pour un matériau diélectrique de 800nm d'épaisseur ayant une constant diélectrique relative de 2, une densité d'état d'interface égale à $6,9.10^{10}/cm^2$ permet un décalage de l'ordre de 5V. Pour un matériau diélectrique de 100nm d'épaisseur ayant une constant diélectrique relative de 2, une densité d'état d'interface égale à $1,1.10^{11}/cm^2$ permet un décalage de l'ordre de 1 V.

De manière avantageuse, la densité d'état est supérieure à $10^9/cm^2$, de préférence inférieure à $10^{12}/cm^2$.

Un mode de réalisation avantageux de dégradation du matériau désiré utilise un rayonnement laser excimère avec des impulsions allant que quelques nanosecondes à quelques dizaines de nanosecondes, de préférence entre 10 et 20ns. La longueur d'onde est comprise dans la gamme ultraviolet, par exemple à la longueur d'onde 248nm ou 385nm. L'énergie délivrée par l'impulsion laser est fonction du matériau irradié. Dans le cas d'un substrat polymère, l'énergie de l'impulsion est avantageusement comprise entre 20mJ/CM$^2$ et 200mJ/cm$^2$. Cette énergie permet de créer un nombre significatif d'état d'interfaces qui sont liés à la rupture de liaisons C-H à l'intérieur du polymère et à la création de liaisons C-OH (hydroxyles) ou C-OOH (acides) à l'interface. L'irradiation laser peut être réalisée sous différentes atmosphères, par exemple sous une atmosphère comprenant de l'oxygène. Le rayonnement ultraviolet est particulièrement intéressant en association avec un substrat de type polymère car l'absorption est importante.

Dans un autre mode de réalisation, la zone de piégeage 9 est disposée entre le diélectrique de grille 6, 7 et le matériau semi-conducteur 2. La zone de piégeage 9 est alors formée par un matériau piégeur qui a des caractéristiques électriques différentes des matériaux constituant le diélectrique de grille 6, 7 et le matériau semi-conducteur 2. Il est également possible de former la zone de piégeage au moyen d'une interface comportant une grande densité d'états de surface. Cette interface peut être formée en dégradant le diélectrique de grille et/ou le matériau semi-conducteur. La dégradation de la surface peut être réalisée par un traitement physique, chimique, laser ou plasma. La dégradation est réalisée sur une monocouche atomique ou avantageusement sur plusieurs couches atomiques typiquement sur quelques nanomètres de profondeur.

De manière générale, la zone de piégeage 9 de charges est une zone qui est apte à conserver pendant une certaine durée de temps les charges qui ont été incorporées. Les charges piégées vont créer une polarisation de la zone de piégeage 9. La zone de piégeage 9 induit alors de manière capacitive une modification des caractéristiques électriques du dispositif. Il devient donc possible de définir au moins deux états dans la cellule mémoire, un état haut et un état bas.

De manière générale, le matériau constituant la zone de piégeage 9 est un matériau polymère conducteur ionique, un matériau polymère qui est chargé avec des particules piégeantes, par exemple des particules métalliques ou ferroélectriques. Le matériau de la zone de piégeage peut également être un matériau diélectrique ou semi-conducteur comportant une densité élevée d'états de surface (non compris dans l'invention). Dans certains cas de figures, le matériau de la zone de piégeage de charge peut être formé par le matériau semi-conducteur organique dégradé, ou dans un des diélectriques de grille également dégradé (non compris dans l'invention).

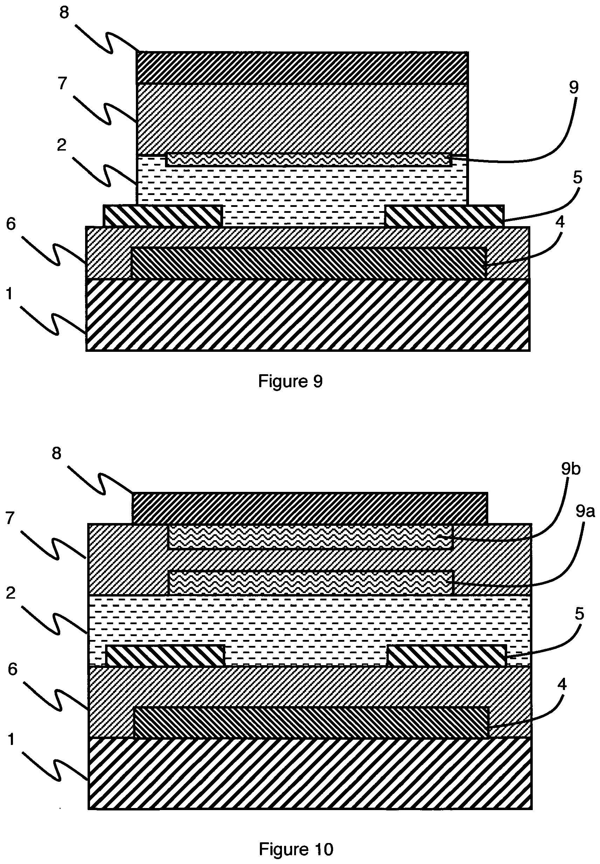

Dans le cas où la zone de piégeage 9 de charges est disposée en contact électrique avec le matériau semi-conducteur organique 2, il est avantageux de former la zone de piégeage par dégradation du premier diélectrique de grille (figure 5) ou du matériau semi-conducteur organique (figure 9).

Dans le cas où la zone de piégeage 9 de charges est disposée en contact électrique avec une électrode de grille 4, 8, il est avantageux d'utiliser une zone de piégeage en matériau polymère conducteur ionique.

Dans une variante de réalisation, illustrée à la figure 10, le dispositif mémoire comporte une zone de piégeage de charges 9 constituée par deux zones de piégeage élémentaires 9a et 9b. Ces deux zones de piégeage élémentaires sont disposées l'une au-dessus de l'autre et séparées par le diélectrique de grille. La première zone de piégeage élémentaire 9a est en contact avec le matériau semi-conducteur organique 2 alors que la seconde zone de piégeage de charge élémentaire 9b est en contact avec une électrode de grille 4, 8. Chaque zone de piégeage élémentaire 9a et 9b répond aux mêmes critères que les zones de piégeage 9 des modes de réalisations précédents. Dans le cas où les zones de piégeage élémentaires 9a et 9b sont superposées, l'effet capacitif est plus élevé ce qui permet d'avoir une tension de charge plus faible. Dans le cas où les zones de piégeage élémentaires 9a et 9b sont sur le même plan, il est alors possible de former une mémoire de type multibit, c'est-à-dire capable de stockée plusieurs bits, ici par exemple deux zones de stockage de un bit.

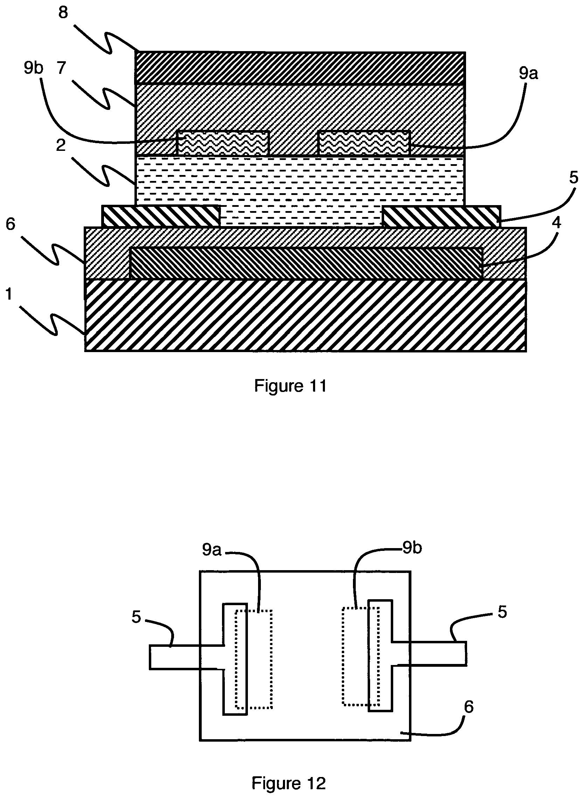

Dans une autre variante de réalisation, illustrée à la figure 11, le dispositif mémoire comporte une zone de piégeage de charges constituée par aux moins deux zones de piégeage élémentaires 9a et 9b. Ces deux zones de piégeage élémentaires sont disposées l'une à coté de l'autre dans un même plan parallèle à la surface du substrat 1. Les différentes zones de piégeage élémentaires sont toutes en contact avec le matériau semi-conducteur organique 2 ou avec une des électrodes de grille. Les zones de piégeage élémentaires forment des lignes parallèles aux électrodes de source et de drains 5 séparées par le diélectrique de grille, c'est-à-dire perpendiculaire au sens de déplacement des porteurs dans le canal et donc à la plus petite distance séparant les deux électrodes. Un exemple de réalisation est illustré à la figure 12, dans lequel deux zones de piégeage élémentaires 9a et 9b sont formées. Ces deux zones de piégeage sont formées sur la grille inférieure 6 avant le dépôt du premier diélectrique de grille et les électrodes de source et de drain 5. Avantageusement, les électrodes de source et de drain 5 sont formées au moins partiellement au-dessus des zones de piégeage élémentaires 9a et 9b, les zones de piégeage ayant des dimensions plus faibles que les électrodes dans la direction perpendiculaire au déplacement des porteurs. Cette structure permet l'obtention d'une mémoire multibits. Dans le mode de réalisation de la figure 12, la grille inférieure n'est pas représentée, il y a formation successivement des zones de piégeage 9a et 9b, du diélectrique inférieur 6 puis des électrodes de source et de drain 5. Le matériau semi-conducteur, le diélectrique supérieur et la grille supérieure sont formés par la suite comme dans le mode de réalisation illustré à la figure 4.

La zone de piégeage 9 est disposée d'un seul coté du dispositif mémoire par rapport au matériau semi-conducteur 2. La zone de piégeage est donc formée entre le matériau semi-conducteur 2 et l'électrode de grille associée à la zone de piégeage. L'électrode associée est l'électrode de grille qui est utilisée pour réaliser l'écriture de l'information. L'autre électrode de grille sert à la lecture de l'information.

Si la zone de piégeage 9 est en contact avec l'électrode de grille d'écriture, la modulation du potentiel de l'électrode de grille permet d'écrire ou d'effacer l'information dans la zone de piégeage.

Si la zone de piégeage 9 est en contact avec le matériau semi-conducteur 2, il faut faire transiter un courant entre les électrodes de source et de drain 5 et il faut appliquer un champ électrique tel que, dans le canal, les porteurs de charge soient dirigés vers la zone de piégeage de charges. Schématiquement, si un courant d'électrons circule entre l'électrode de source et l'électrode de drain, l'électrode de grille d'écriture a un potentiel plus positif que celui du canal de sorte à attirer les électrons vers la zone de piégeage disposée entre le courant d'électrons et la grille d'écriture.

Les porteurs de charge électrique qui sont piégés dans la zone de piégeage 9 vont modifier, par effet capacitif, les caractéristiques du transistor à simple grille qui est formé par la grille de lecture et les électrodes de source et de drain 5 disposées de part et d'autre du canal. Si la zone de piégeage est disposée en regard de ce qui est assimilé au canal, les charges accumulées vont modifier la conduction dans le canal. Si la zone de piégeage est disposée en regard du matériau semi-conducteur disposé au-dessus ou en dessous d'une des électrodes de source et de drain, la résistance d'injection de l'électrode est modifiée.

Cette architecture de dispositif mémoire est particulièrement avantageuse car il n'y a pas utilisation de l'électrode de grille d'écriture pour réaliser la lecture de l'information. Ainsi, le dispositif mémoire est particulièrement robuste aux phénomènes de perturbations par lecture (« read disturb » en anglais) dans lesquels l'information est plus ou moins effacée ou altérée à chaque lecture.

Dans ce dispositif mémoire organique, les charges de la zone de piégeage 9 proviennent de l'électrode de grille ou du canal du transistor par conduction et non par un effet tunnel car l'effet tunnel est difficilement applicable dans les couches épaisses des technologies d'impression utilisées dans ce domaine.

D'une manière générale, le dispositif mémoire est formé selon le procédé de réalisation suivant qui comprend :

- la formation de la première électrode de grille 4,
- la formation du premier diélectrique de grille 6,
- la formation des électrodes de source et de drain 5 en contact avec le matériau semi-conducteur organique 2, les électrodes de source et de drain définissant une surface inter-électrodes,

- la formation du second diélectrique de grille 7,
- la formation de la seconde électrode de grille 8.

Au regard des différents modes de réalisation possibles, il est également nécessaire qu'il y ait la formation de la zone de piégeage 9 de charges électriques entre le matériau semi-conducteur organique 2 et une des électrodes de grille 4, 8. Comme précisé plus haut, il est également nécessaire que la zone de piégeage 9 soit en contact électrique avec une des électrodes de grille 6, 7 ou avec le matériau semi-conducteur organique 2. De même, la zone de piégeage 9 doit être au moins en regard de la surface inter-électrodes afin que l'on ait un effet capacitif qui agisse sur le fonctionnement du transistor formé avec la grille de lecture.

De manière un peu plus détaillée, le dispositif mémoire peut être réalisé de la manière suivante, à partir d'un substrat 1 quelconque en matériau non conducteur pour éviter les court-circuits entres les différents dispositifs. Le substrat 1 est, par exemple, un substrat en verre, polyimide, polyéthylène téréphtalate ou un polyéthylène naphtalate.

Une première électrode de grille 4 est formée sur le substrat 1, de manière conventionnelle. Cette première électrode de grille 4 est réalisée, par exemple, en matériau métallique, par exemple de l'or avec une épaisseur comprise entre 30 et 100nm, ou en polymère conducteur comme un mélange de poly(styrène-sulfonate) de sodium dit « PSS » et de poly(3,4-éthylène-dioxythiophène) dit « PEDOT » ou à partir d'une encre à base de particules métalliques. La première électrode de grille 4 peut être formée par sérigraphie ou alors par un dépôt suivie d'une étape de photolithographie et de gravure. La structuration de la première électrode de grille 4 peut également être réalisée par ablation laser à travers un masque ou par photolithographie.

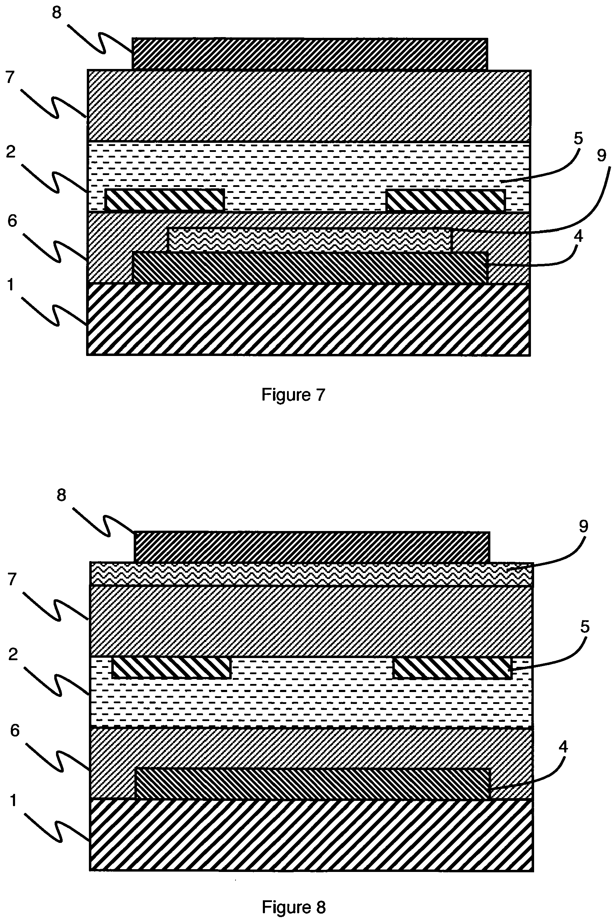

Dans un mode de réalisation particulier, illustré à la figure 7, le matériau piégeur de la zone de piégeage 9, est déposé sur la première électrode de grille 4. Ce matériau piégeur peut être déposé de manière sélective afin de ne former que la zone de piégeage 9. Le matériau piégeur peut également être déposée de manière « pleine plaque » et être structuré pour délimiter la zone de piégeage 9. La zone de piégeage 9 peut être formée, par exemple, par sérigraphie ou par un dépôt suivie d'une étape de photolithographie et de gravure.

Le premier diélectrique de grille 6 est alors déposé sur le substrat 1 au-dessus de la première électrode de grille 4. Le premier diélectrique de grille 6 est un matériau isolant, par exemple un oxyde de silicium ou un polymère réticulable, avantageusement réticulable sous un rayonnement ultraviolet. Le premier diélectrique de grille 6 peut être déposé par voie liquide et durci ensuite, par exemple, au moyen d'un rayonnement ultraviolet. L'utilisation d'un masque d'insolation associé au rayonnement ultraviolet est avantageuse pour définir les zones dans lesquelles le premier diélectrique de grille 6 doit être conservé. La structuration du premier diélectrique de grille 6 définit la forme et la taille du premier diélectrique de grille 6 et elle définit également les zones qui autorisent la prise de contact pour la première électrode de grille 4.

Les électrodes de source et de drain 5 sont alors formées sur le premier diélectrique de grille 6, ces électrodes de source et de drain 5 sont dans un matériau électriquement conducteur choisi dans le même groupe de matériaux que celui de la première électrode de grille 4. Les électrodes de source et de drain 5 sont formées par sérigraphie ou alors par une étape de dépôt suivie d'une étape de photolithographie et de gravure. Avantageusement, les électrodes de source et de drain 5 sont formées par évaporation suivie d'une structuration, par exemple par ablation laser.

Dans un mode de réalisation particulier illustré à la figure 5, la zone de piégeage 9 est disposée sous le canal entre le matériau semi-conducteur 2 et le premier matériau diélectrique 6. Dans ce mode de réalisation particulier, il est particulièrement avantageux de former la zone de piégeage 9 en même temps que l'on structure les électrodes de source et de drain 5. Dans ce mode de réalisation particulier, le matériau piégeur de charges est formé avantageusement dans le premier diélectrique de grille 6 en le dégradant. Cette dégradation peut être réalisée par le faisceau laser qui sert à structurer les électrodes de source et de drain 5. Ainsi, avec le même rayonnement laser, il y a simultanément formation des électrodes de source et de drain 5 et formation de la zone de piégeage 9.

Dans le cas où les électrodes de source et de drain 5 sont disposées au dessus du matériau semi-conducteur organique 2, c'est-à-dire entre le matériau semi-conducteur organique 2 et le second diélectrique de grille 7, il est également avantageux d'utiliser la structuration des électrodes de source et de drain 5 pour former la zone de piégeage 9. La zone de piégeage 9 est alors formée dans le matériau semi-conducteur organique 2 par dégradation (non compris dans l'invention).

Comme précédemment, la dégradation peut être réalisée par un rayonnement laser ou par un traitement thermique, typiquement une gravure. Le matériau semi-conducteur organique 2 est ensuite déposé sur le substrat 1, sur le premier diélectrique de grille 2 et sur les électrodes de source et de drain 5. Le matériau semi-conducteur organique 2 est, par exemple, un matériau polymère amorphe tel que le poly tri-arylamine (PTAA) ou le poly(9,9-dialkylfluorene-alt-triarylamine) (TFB) ou un matériau en petites molécules cristallisées tel que le poly(3-hexyl)thiophène (P3HT) ou le poly(quaterthiophène) (PQT). Quand le matériau semi-conducteur 2 est déposé par voie liquide, le matériau semi-conducteur 2 est associé, avantageusement, à un solvant qui ne dégrade pas les couches déjà formées. Le matériau semi-conducteur 2 est associé, par exemple, à un solvant de type toluène. Le matériau semi-conducteur 2 est typiquement un dérivé du pentacène, par exemple un triisopropylsilyl pentacène (TIPS-pentacène), qui est soluble dans le toluène ou le xylène.

Le second diélectrique de grille 7 est déposé sur le matériau semi-conducteur organique 2. Ce second diélectrique de grille 7 peut être déposé par toute technique adaptée, notamment par voie liquide dans un solvant qui est sans effet sur le matériau semi-conducteur organique 2. Il est avantageux d'utiliser un solvant fluoré, par exemple, le Cytop™ (nom commercial pour le poly fluoro butenyl vynil éther commercialisé par ASHAI GLASS). Le second diélectrique de grille 7 est mis en forme par exemple par évaporation du solvant, typiquement par un recuit. Le second diélectrique de grille 7 peut être dans le même matériau que le premier diélectrique de grille 6 ou dans un matériau différent.

Dans un autre mode de réalisation, illustré à la figure 2, la zone de piégeage 9 est formée entre le second diélectrique de grille 7 et la seconde électrode de grille 8. Le matériau piégeur est formé dans le second diélectrique de grille 7 ou au-dessus du second diélectrique de grille 7. Le matériau piégeur est, par exemple, en électrolyte ionique liquide ou solide comme le nafion® déposé de façon localisée au-dessus du second diélectrique de grille 7 par voie liquide. Le dépôt localisé par voie liquide est effectué, typiquement par jet d'encre, par sérigraphie ou par héliographie dans un solvant polaire qui est par exemple de l'éthanol ou de l'eau. L'utilisation d'un solvant polaire est avantageuse, car le solvant polaire est sans effet sur le second diélectrique de grille 7 qui est typiquement sensible à un solvant fluoré.

La seconde électrode de grille 8 est formée sur le second diélectrique de grille 7 ou sur le second diélectrique 7 et la zone de piégeage 9. La formation de la seconde électrode de grille 8 est réalisée de manière conventionnelle, par exemple, par voie d'impression ou par évaporation. Le matériau de la seconde électrode de grille 8 est choisi parmi les mêmes matériaux que la première électrode de grille 4. Les première et seconde électrodes de grille 4 et 8 peuvent être dans des matériaux identiques ou alors dans des matériaux différents.

A titre d'exemple, la distance séparant les électrodes de source ou de drain 5 est inférieure à 100 micromètres, typiquement entre 5 et 100 micromètres. Les électrodes de grilles 4 et 8 ont une longueur inférieure à 100 micromètres, typiquement entre 5 et 100 micromètres. Il n'est pas nécessaire que les deux grilles aient les mêmes dimensions. L'épaisseur des premier 6 et second 7 diélectriques de grille est inférieure à 5 micromètres, typiquement entre 100 nanomètres et 1 micromètre. Les épaisseurs des deux diélectriques de grille 6 et 8 peuvent être différentes. L'épaisseur du matériau semi-conducteur organique 2 est inférieure à 1 micromètre, typiquement, l'épaisseur est comprise entre 50 nanomètres et 200 nanomètres. Une épaisseur supérieure à 50 nanomètres permet d'obtenir un transistor qui présente de bonnes performances en conduction des charges alors qu'une épaisseur inférieure à 200nm autorise un couplage suffisant entre les deux électrodes de grille 4 et 8 pour pouvoir être utilisé comme dispositif mémoire. Les dimensions de la mémoire sont données à titre indicatif et peuvent être plus faible que celle présentées en fonction des performances électriques que présentent les différents matériaux utilisés.

Ce dispositif peut être mis en oeuvre par des techniques d'impression dites « grande surface » ce qui est particulièrement avantageux pour réaliser un grand nombre de composants sur un même substrat.

Dans encore une autre variante de réalisation, il est également envisageable de combiner une couche en nafion avec une dégradation du diélectrique de grille pour former une seule zone de piégeage ce qui permet d'améliorer l'effet de piégeage.

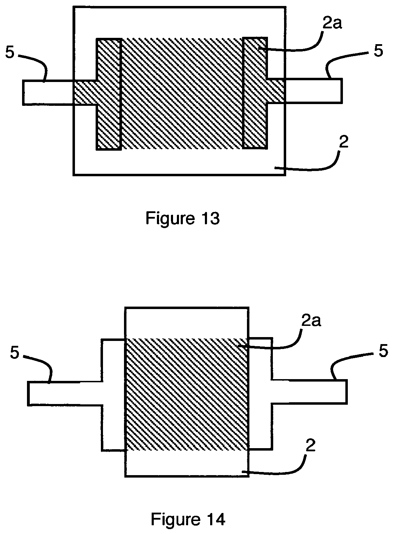

Les figures 13 et 14 illustrent de manière schématique, en vue de dessus, l'étendue de la surface inter-électrodes selon différents modes de réalisation. Sur les figures 13 et 14 seuls le matériau semi-conducteur 2 et les électrodes de source et de drain 5 sont représentés. A la figure 13, le matériau semi-conducteur 2 recouvre ou est recouvert par les électrodes de source et de drain 5, dans ces conditions, la surface inter-électrodes 2a (représentée en hachurée) comporte la surface de contact entre les électrodes 5 et le matériau semi-conducteur 2 ainsi que la surface de la zone de matériau semi-conducteur 2 qui est comprise entre les deux électrodes 5. Quand les électrodes ont des formes simples, comme représenté à la figure 13, la zone de semi-conducteur est délimitée par les surfaces en regard des électrodes 5 et des lignes fictives relient les extrémités de ces deux surfaces en regard.

A la figure 14, le matériau semi-conducteur 2 ne recouvre ni n'est recouvert par les électrodes de source et de drain 5. Ce mode de réalisation est à rapproché de celui illustré à la figure 5. Dans ce cas, la surface inter-électrodes 2a (représentée en hachurée) correspond uniquement à la surface occupée par la zone de matériau semi-conducteur 2 qui est comprise entre les deux électrodes 5.

La surface inter-électrodes 2a du matériau semi-conducteur 2 est une surface définie dans un plan parallèle au substrat 1, c'est-à-dire parallèle à la surface du substrat 1 sur laquelle sont déposées les différentes couches. Cette surface inter-électrodes 2a du matériau semi-conducteur 2 est délimitée par les électrodes de source et de drain 5 car ces électrodes sont utilisées pour former les lignes fictives de délimitation.

**Revendications**

**1.** Transistor à double grilles comportant :

- une première électrode de grille (4),
- un premier diélectrique de grille (6),
- un matériau semi-conducteur organique (2),
- une seconde électrode de grille (8), les première et seconde électrodes de grille (4, 8) étant disposées de part et d'autre du matériau semi-conducteur organique (2),
- un second diélectrique de grille (7),
- des électrodes de source et de drain (5) délimitant une surface inter-électrodes (2a) du matériau semi-conducteur (2),
- un matériau piégeur des charges électriques (9) disposé entre le matériau semi-conducteur organique (2) et une des électrodes de grille (4, 8), le matériau piégeur (9) étant au moins partiellement en regard de la surface inter-électrodes (2a),

transistor **caractérisé en ce que** le matériau piégeur (9) est en contact électrique par conduction, et non par un effet tunnel, avec une des électrodes de grille (4, 8) ou avec le matériau semi-conducteur organique (2), et **en ce que** le matériau piégeur (9) est en matériau polymère conducteur ionique.

**2.** Dispositif selon la revendication 1, **caractérisé en ce que** le matériau piégeur de charges (9) comporte un squelette de type poly(tetrafluoroethylene) sur lequel sont greffées des chaînes pendantes perfluorées terminées par des groupes sulfoniques.

**3.** Dispositif selon l'une quelconque des revendications 1 à 2, **caractérisé en ce qu'**il comporte des zones de piégeages élémentaires (9a, 9b) en matériau piégeur de charges (9).

**4.** Procédé de fabrication d'un dispositif mémoire comportant :

- la formation d'une première électrode de grille (4),
- la formation d'un premier diélectrique de grille (6),
- la formation des électrodes de source et de drain (5) en contact avec un matériau semi-conducteur organique (2), les électrodes de source et de drain définissant une surface inter-électrodes (2a),
- la formation d'un second diélectrique de grille (7),
- la formation d'une seconde électrode de grille (8), les première et seconde électrodes de grille (4, 8) étant disposées de part et d'autre du matériau semi-conducteur organique (2),
- la formation d'un matériau piégeur (9) de charges électriques entre le matériau semi-conducteur organique (2) et une des électrodes de grille (4, 8), le matériau piégeur (9) étant au moins partiellement en regard de la surface inter-électrodes (2a),

**caractérisé en ce que** le matériau piégeur (9) formé est en contact électrique par conduction, et non par effet tunnel, avec une des électrodes de grille (4, 8) ou avec le matériau semi-conducteur organique (2), et **en ce que** le matériau piégeur (9) formé est en matériau polymère conducteur ionique.

## Patentansprüche

1. Dual-Gate-Transistor, umfassend:

    - eine erste Gate-Elektrode (4),
    - ein erstes Gate-Dielektrikum (6),
    - ein organisches Halbleitermaterial (2),
    - eine zweite Gate-Elektrode (8), wobei die erste und die zweite Gate-Elektrode (4, 8) auf beiden Seiten des organischen Halbleitermaterials (2) angeordnet sind,
    - ein zweites Gate-Dielektrikum (7),
    - Source- und Drain-Elektroden (5), die eine Zwischenelektrodenfläche (2a) des Halbleitermaterials (2) begrenzen,
    - ein die elektrischen Ladungen einfangendes Material (9), das zwischen dem organischen Halbleitermaterial (2) und einer der Gate-Elektroden (4, 8) angeordnet ist, wobei das Einfangmaterial (9) wenigstens teilweise gegenüber der Zwischenelektrodenfläche (2a) liegt,

    Transistor, **dadurch gekennzeichnet, dass** das Einfangmaterial (9) mit einer der Gate-Elektroden (4, 8) oder mit dem organischen Halbleitermaterial (2) durch Leitung, und nicht durch einen Tunneleffekt, in elektrischem Kontakt ist, und dass das Einfangmaterial (9) aus leitendem ionischem Polymermaterial besteht.

2. Vorrichtung nach Anspruch 1, **dadurch gekennzeichnet, dass** das Ladungseinfangmaterial (9) ein Gerüst vom Typ Poly(tetrafluorethylen) umfasst, auf das Sulfongruppen-terminierte, perfluorierte Seitenketten gepfropft sind.

3. Vorrichtung nach einem der Ansprüche 1 bis 2, **dadurch gekennzeichnet, dass** sie Einzeleinfangbereiche (9a, 9b) aus Ladungseinfangmaterial (9) umfasst.

4. Verfahren zur Herstellung einer Speichervorrichtung, umfassend:

    - das Ausbilden einer ersten Gate-Elektrode (4),
    - das Ausbilden eines ersten Gate-Dielektrikums (6),
    - das Ausbilden der Source- und Drain-Elektroden (5) in Kontakt mit einem organischen Halbleitermaterial (2), wobei die Source- und Drain-Elektroden eine Zwischenelektrodenfläche (2a) definieren,
    - das Ausbilden eines zweiten Gate-Dielektrikums (7),
    - das Ausbilden einer zweiten Gate-Elektrode (8), wobei die erste und die zweite Gate-Elektrode (4, 8) auf beiden Seiten des organischen Halbleitermaterials (2) angeordnet sind,
    - das Ausbilden eines Materials zum Einfangen (9) von elektrischen Ladungen zwischen dem organischen Halbleitermaterial (2) und einer der Gate-Elektroden (4, 8), wobei das Einfangmaterial (9) wenigstens teilweise gegenüber der Zwischenelektrodenfläche (2a) liegt,

    **dadurch gekennzeichnet, dass** das ausgebildete Einfangmaterial (9) mit einer der Gate-Elektroden (4, 8) oder mit dem organischen Halbleitermaterial (2) durch Leitung, und nicht durch Tunneleffekt, in elektrischem Kontakt ist, und dass das ausgebildete Einfangmaterial (9) aus leitendem ionischem Polymermaterial besteht.

## Claims

1. A double-gate transistor comprising:

    - a first gate electrode (4),
    - a first gate dielectric (6),
    - an organic semiconductor material (2),
    - a second gate electrode (8), the first and second gate electrodes (4, 8) being disposed on either sides of the organic semiconductor material (2),
    - a second gate dielectric (7),
    - source and drain electrodes (5) delineating an inter-electrode surface (2a) of the semiconductor material (2),
    - an electric charge trapping material (9) arranged between the organic semiconductor material (2) and one of the gate electrodes (4, 8), the trapping material (9) being at least partially facing of the inter-electrode surface (2a),

    a transistor **characterized in that** the trapping material (9) is in electric contact by conduction, and not by tunnel effect, with one of the gate electrodes (6, 7) or with the organic semiconductor material (2), and **in that** the trapping material (9) is made from ionic conductive polymer material.

2. The device according to claim 1, **characterized in that** the charge trapping material (9) comprises a skeleton of poly(tetrafluoroethylene) type on which perfluorinated dangling chains terminated by sulfonic groups are grafted.

3. The device according to one of claims 1 and 2, **characterized in that** it comprises elementary trapping areas (9a, 9b) made from the charge trapping material (9).

4. A method for producing a memory device comprising:

- formation of a first gate electrode (4),
- formation of a first gate dielectric (6),
- formation of the source and drain electrodes (5) in contact with an organic semiconductor material (2), the source and drain electrodes defining an inter-electrode surface (2a),
- formation of a second gate dielectric (7),
- formation of a second gate electrode (8), the first and second gate electrodes (4, 8) being disposed on either sides of the organic semiconductor material (2),
- formation of an electric charge trapping material (9) between the organic semiconductor material (2) and one of the gate electrodes (4, 8), the trapping material (9) being at least partially facing of the inter-electrode surface (2a),

**characterized in that** the formed trapping material (9) is in electric contact by conduction, and not by tunnel effect, with one of the gate electrodes (4, 8) or with the organic semiconductor material (2), and **in that** the trapping material (9) is made from ionic conductive polymer material.

Figure 1 (Art antérieur)

Figure 2

Figure 3

Figure 4

Figure 5

Figure 6

Figure 7

Figure 8

Figure 9

Figure 10

Figure 11

Figure 12

Figure 13

Figure 14

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

Documents brevets cités dans la description...

- US 20090101962 A
- EP 1367659 A